Europäisches Patentamt

European Patent Office

Office européen des brevets

(19)

(11) Numéro de publication: **0 206 919**
**B1**

(12) **FASCICULE DE BREVET EUROPEEN**

(45) Date de publication du fascicule du brevet:
06.06.90

(21) Numéro de dépôt: 86401301.6

(22) Date de dépôt: 16.06.86

(51) Int. Cl.⁵: **C08K 3/00**, C08K 3/22,
C08L 67/02, B41M 1/30,
B41M 5/26
// H01L23/29

(54) Résine d'enrobage pour marquage thermique.

(30) Priorité: 18.06.85 FR 8509245

(43) Date de publication de la demande:
30.12.86 Bulletin 86/52

(45) Mention de la délivrance du brevet:
06.06.90 Bulletin 90/23

(84) Etats contractants désignés:
DE GB IT

(56) Documents cités:
EP-A- 0 036 680
EP-A- 0 105 451

Additives for plastics, vol.2, pages 114-119 (ACADEMIC PRESS)
Taschenbuch der Kunststoff-Additive, pages 446-447 (Hanser Verlag)
Encyclopedia of Polymer Science and Technology, vol.10, pages 164-165

Le dossier contient des informations techniques présentées postérieurement au dépôt de la demande et ne figurant pas dans le présent fascicule.

(73) Titulaire: COMPAGNIE EUROPEENNE DE COMPOSANTS ELECTRONIQUES LCC, 50, rue Jean -Pierre Timbaud B.P. 301, F-92402 Courbevoie(FR)

(72) Inventeur: Bernard, Gilles, THOMSON-CSF SCPI 19, avenue de Messine, F-75008 Paris(FR)

(74) Mandataire: Ruellan-Lemonnier, Brigitte et al, THOMSON-CSF SCPI, F-92045 PARIS LA DEFENSE CEDEX 67(FR)

## Description

La présente demande de brevet concerne les résines d'enrobage du type thermoplastique ou thermodurcissable destinées à recevoir une inscription par effet thermique. Cet effet thermique peut être induit par rayonnement, par exemple à l'aide d'un faisceau laser, ou par un autre système de marquage à chaud.

Les résines thermoplastiques ou thermodurcissables sont souvent employées dans l'industrie électronique pour enrober des composants électriques afin d'assurer leur protection mécanique et leur isolation électrique. Comme ces composants doivent être repérés de manière sûre et efficace, il est avantageux de graver la résine pour indiquer la valeur électrique du composant de même que la marque du fabricant. La gravure de la résine peut s'effectuer de différentes manières. Le procédé de marquage thermique a l'avantage de la rapidité de mise en œuvre. Il peut être obtenu par un faisceau laser. Il est connu également de marquer une résine par le changement de couleur d'un additif par effet thermique. Un tel procédé de marquage est décrit dans EP 36680. Le seul inconvénient du marquage thermique est le manque de contraste entre l'inscription et le support en résine.

Afin de pallier ces inconvénients, l'invention propose d'ajouter à la résine d'enrobage des composants des additifs appropriés dont la couleur, sous l'effet de la chaleur, se détache nettement de celle de la résine d'enrobage. Cette distinction entre la résine support et le ou les additifs peut être obtenue par des changements de couleur induits par effet thermique. De telles résines inscriptibles peuvent servir non seulement à enrober des composants, mais également des ensembles de composants constituant des circuits.

L'invention a donc pour objet une résine d'enrobage pour marquage thermique, comprenant une résine de base thermoplastique ou thermodurcissable et au moins un additif de marquage, caractérisée en ce que la résine de base est une résine polyépoxyde, polyuréthane, polyester, du polypropylène, du polybutylène téréphtalate ou du polychlorure de vinyle, et que l'additif est un oxyde de fer jaune ou un oxyde de plomb (PbO).

L'effet thermique sera avantageusement obtenu par l'impact d'un rayon laser.

Les additifs constitués par des carbonates, des oxydes ou des chlorures de métaux, par exemple des oxydes de fer jaunes ou l'oxyde de plomb PbO, se révèlent particulièrement efficaces.

L'invention propose donc d'introduire, dans une matrice thermoplastique ou thermodurcissable, un ou plusieurs additifs organiques ou minéraux qui, sous l'effet thermique induit par exemple par un rayon laser, puissent changer de couleur et provoquer un contraste entre les parties chauffées et non chauffées.

Dans le cas d'additifs minéraux, on peut utiliser, entre autres, des carbonates, des oxydes et des chlorures de métaux tels que le fer, le zinc, le manganèse, le plomb. Le choix de l'additif, minéral ou organique, est déterminé par la couleur de la résine d'enrobage. Il faut, pour une résine de couleur déterminée, choisir un additif qui ressort suffisamment pour procurer une lecture rapide.

A titre d'exemple, des oxydes de fer jaunes (oxydes ferreux) introduits à un taux de 5 % en poids dans une résine DGEBA (diglycidyl éther de biphénol A) procurent des résines inscriptibles par rayon laser. Ces oxydes de fer sont commercialisés sous la marque DEANOX. Ils sont introduits dans une résine DGEBA liquide dans laquelle on ajoute un anhydride comme durcisseur. On peut utiliser comme anhydride le MTHPA (méthyltétrahydrophtalique anhydride). Ceci fournit une résine de coulée (ou de potting) liquide qui, lorsqu'elle est durcie, peut être marquée sous l'effet d'un rayon laser. Le marquage est alors de couleur rouge-violet sur fond jaune.

Un autre exemple est fourni par l'oxyde de plomb PbO qui, introduit à un taux de l'ordre de 10 % en poids dans une matrice organique telle que DGEBA, donne sous l'effet d'un rayon laser un marquage noir sur fond jaune.

Les additifs précités peuvent être introduits dans des résines époxydes, polyuréthanes, polyesters, etc. ou dans des thermoplastiques PP (polypropylène), PBT (polybutylène téréphtalate), PVC (polychlorure de vinyle), etc. Ceci, bien sûr, dans la mesure d'une bonne compatibilité ou d'une bonne dispersion des additifs dans la résine. Il convient également que la température de mise en oeuvre de la résine (c'est-à-dire permettant l'enrobage des composants) soit inférieure à la température de révélation de l'additif ou des additifs le cas échéant.

Les additifs peuvent être introduits par simple mélange au moment de la préparation de la résine d'enrobage. On peut procéder à un dégazage après le malaxage du mélange ainsi constitué. La proportion en additif dans la résine est fonction des produits constituant le mélange. Pratiquement, les additifs représentent quelques pour cent en poids de la résine.

Grâce à l'invention, des résines thermodurcissables classiques du type lit fluidisé, de coulée, MIL (moulage injection liquide), transfert poudre, peuvent être marquées par rayon laser. Il en va de même pour tout thermoplastique.

Le rayon servant à l'inscription peut indifféremment être généré par un laser YAG, $CO_2$ ou infrarouge. Le rayon laser peut être pulsé ou continu. L'énergie nécessaire pour obtenir un marquage correct dépend principalement de l'aptitude au changement de couleur de l'additif introduit dans la résine. A titre d'exemple, une énergie de 1,2 joule fournie par un laser $CO_2$ est suffisante pour inscrire une résine époxyde classique contenant un taux de 1 à 5 % d'oxyde de fer.

L'application principale mais non limitative de ces résines inscriptibles est l'enrobage de composants électroniques.

## Revendications

1. Résine d'enrobage pour marquage thermique, comprenant une résine de base thermoplastique ou thermodurcissable et au moins un additif de marquage, caractérisée en ce que la résine de base est une résine polyépoxyde, polyuréthane, polyester, du polypropylène, du polybutylène téréphtalate ou du polychlorure de vinyle, et que l'additif est un oxyde de fer jaune ou un oxyde de plomb (PbO).

2. Résine d'enrobage selon la revendication 1, caractérisée en ce que la résine de base est du diglycidyl éther de bisphénol A (DGEBA).

## Claims

1. A coating resin for thermal recording, comprising a thermoplastic or thermosetting base resin and at least one recording additive, characterized in that the base resin is an epoxy resin, a polyurethane resin, a polyester resin, polypropylene, polybutylene terephthalate or polyvinyl chloride and the additive is yellow iron oxide or a lead oxide (PbO).

2. The coating resin as claimed in claim 1, characterized in that the base resin is bisphenol A diglycidyl ether (BADGE).

## Patentansprüche

1. Thermisch beschriftbares Umhüllungsharz, umfassend ein thermoplastisches oder duroplastisches Grundharz und mindestens ein Beschriftungsadditiv, dadurch gekennzeichnet, daß das Grundharz ein Polyepoxid-, Polyurethan-, Polyester-Harz, Polypropylen, Polybutylenterephthalat oder Polyvinylchlorid ist und daß das Additiv ein gelbes Eisenoxid oder ein Bleioxid (PbO) ist.

2. Umhüllungsharz nach Anspruch 1, dadurch gekennzeichnet, daß das Grundharz Bisphenol A-Diglycidylether (DGEBA) ist.